(19) Europäisches Patentamt
European Patent Office
Office européen des brevets

(11) **EP 2 775 313 A1**

(12) **DEMANDE DE BREVET EUROPEEN**

(43) Date de publication:
**10.09.2014 Bulletin 2014/37**

(51) Int Cl.:
***G01R 31/36*** *(2006.01)*

(21) Numéro de dépôt: **14305265.2**

(22) Date de dépôt: **26.02.2014**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**

(30) Priorité: **06.03.2013 FR 1351991**

(71) Demandeur: **IFP Energies nouvelles
92852 Rueil Malmaison Cedex (FR)**

(72) Inventeurs:
• **Creff, Yann
38138 Les Côtes 'Arey (FR)**
• **Prada, Eric
69007 Lyon (FR)**
• **Di Domenico, Domenico
69007 Lyon (FR)**
• **Pognant-Grod, Philippe
69340 Francheville (FR)**

(54) **Procédé de détermination de la capacité résiduelle d'une batterie**

(57) L'invention concerne un procédé de détermination de la capacité résiduelle d'une cellule électrochimique de stockage d'énergie électrique au moyen d'un modèle de tension à vide de la cellule, le modèle étant paramétré, de telle sorte que le paramètre représente le vieillissement de la cellule. Le paramétrage du modèle est réalisé à partir de séries de mesures réalisées sur la batterie comportant au moins une mesure de tension, une mesure de température et une mesure de courant de la cellule.

Figure 2

EP 2 775 313 A1

**Description**

La présente invention concerne le domaine de l'étude du vieillissement des batteries, notamment des batteries pour véhicules automobiles. Plus particulièrement, l'invention concerne un procédé de détermination de la capacité résiduelle d'une batterie.

Pour cette demande, l'appellation générique batterie regroupe tous ces termes : batterie, pack, module et cellule. Les batteries et les packs sont constitués d'une ou plusieurs cellules électrochimiques de stockage d'énergie électrique (qui est le composant électrochimique unitaire d'une batterie) et sont par définition dotés d'un système de gestion de batterie BMS (de l'anglais "Battery Management System"). Les modules sont des ensembles de cellules électrochimiques de stockage d'énergie. Dans la suite de la description, le terme batterie est donc utilisé pour désigner à la fois une batterie entière ou une cellule ou en ensemble de cellules, avec ou sans système de gestion de batterie BMS.

Au fur et à mesure de son utilisation, plusieurs caractéristiques physiques des constituants de la cellule (électrodes et électrolytes) varient. On parle de vieillissement de la cellule. Celui-ci a diverses origines, mais entraîne notamment une modification de la tension à vide de la cellule et une diminution de sa capacité. Généralement, une batterie est considérée en fin de vie, lorsqu'elle a perdu 30% de sa capacité initiale.

La connaissance de la charge résiduelle d'une batterie permet de définir un état de charge réel, défini à partir d'une capacité réelle prenant en compte le vieillissement de la batterie. De plus, la capacité résiduelle de la batterie permet également de définir un état de santé SOH (de l'anglais "State of Health") de celle-ci.

L'invention concerne notamment les batteries de traction électriques utilisées dans les véhicules notamment électriques ou hybrides pour lesquels il est indispensable de mettre en oeuvre une gestion intelligente de l'énergie électrique.

L'évolution de l'énergie d'une batterie est directement liée à sa perte de capacité au cours du temps. Elle dépend ainsi directement du degré de vieillissement de la batterie. Ce dernier est propre à chaque utilisation du véhicule, c'est-à-dire à l'historique de chaque batterie embarqué au sein du véhicule.

Pour déterminer les caractéristiques des batteries, on peut relever plusieurs types d'approches décrites dans la littérature, il s'agit essentiellement :

- d'approches basées sur le suivi au cours de la vie de la batterie du spectre d'impédance électrochimique (paramétré en état de charge et en température). Ces approches se basent sur tout ou partie de la gamme de fréquences du spectre.
- d'approches basées sur l'identification en ligne de la valeur de paramètres constitutifs d'un circuit équivalent représentatif du fonctionnement de la batterie. On trouve souvent l'identification d'une simple résistance (équivalente à la résistance interne), et des circuits équivalents un peu plus complexes, comme une résistance interne plus un (ou plusieurs) ensemble(s) résistance et condensateur.
- d'approches "boucle ouverte", permettant de calculer un indice de vieillissement, dont l'évolution dépend le plus souvent des trajectoires de la température et de l'intensité, ainsi que des taux de charge ou de décharge. Pour ce type d'approches, on trouve des formules empiriques (qui peuvent utiliser une analogie cinétique avec des lois de vieillissement exponentielles) ou des cartographies de sévérité.

Pour résoudre ces problèmes, les demandes de brevet DE 10 2010 019 128 A1 et FR 2 946 150 A1 décrivent des méthodes d'estimation de la capacité d'une batterie électrique au moyen de mesures. Toutefois, les méthodes décrites dans ces documents présentent plusieurs inconvénients.

Elles ne permettent notamment pas de modéliser précisément le vieillissement de la batterie. Pour ces deux méthodes, on utilise le même type de mesures : deux tensions à des points stabilisés et l'intégrale du courant entre ces deux points stabilisés, ces méthodes utilisent les courbes de tension à vide, toutefois la dépendance en température de ces courbes ne semble pas vraiment exploitée. En effet, pour la demande de brevet DE 10 2010 019 128 A1, on recherche, parmi les courbes disponibles donnant la tension à vide en fonction du SOC (état de charge, de l'anglais "State of Charge") et du vieillissement, celle pour laquelle le delta de SOC donné par l'intégrale fournit les deux valeurs de tension mesurées. Cette méthode ne décrit pas la gestion du fait que les deux points pour lesquels sont mesurées les tensions peuvent à des températures différentes. Par ailleurs, la demande de brevet FR 2 946 150 procède de manière différente, en passant par la notion de pente (représentation de la tension à vide par une droite entre les deux valeurs de tension mesurées). L'observation d'une certaine pente, pour une intégrale donnée, doit correspondre, à la température donnée, à une certaine capacité résiduelle. Ceci requiert la connaissance a priori de l'ensemble de ces pentes.

De plus, pour les deux demandes de brevet, on passe par une notion de charge relative à la capacité (SOC pour le brevet allemand, profondeur de décharge pour le brevet français) pour la paramétrisation des tensions à vide. Pour le brevet français, ceci revient à considérer qu'on connaît, via la première tension mesurée, l'état de charge.

En outre, pour les deux demandes de brevet, seuls deux points de mesure sont utilisés. Ce qui rend les calculs sensibles aux erreurs de mesure, sur la tension et le courant.

Par ailleurs, les deux demandes de brevet prétendent disposer a priori de toutes les courbes possibles de tension à vide, ce qui semble très difficile car cela nécessite de préjuger de la manière dont la cellule vieillit.

Ainsi, l'invention concerne un procédé de détermination de la capacité résiduelle d'une cellule électrochimique au moyen d'un modèle paramétré représentant le vieillissement de la cellule. Le paramétrage du modèle est réalisé à partir de séries de mesures réalisées sur la batterie. L'utilisation du modèle paramétré au moyen de mesures permet de rendre compte précisément de l'état initial de la batterie, en effet dans le procédé selon l'invention, on passe par un paramétrage de la courbe de tension à vide par des facteurs représentatifs de modes de vieillissement, ce paramétrage ne nécessitant pas la connaissance de l'état de charge de la batterie. L'invention permet d'exploiter pour la détermination de la capacité résiduelle un nombre important de mesures, ce qui permet de limiter les effets indésirables liés aux erreurs de mesure. Enfin, la présente invention permet d'utiliser des triplets de mesures pour lesquels la température n'a pas la même valeur pour les deux mesures de tension, ce qui permet a priori une mise à jour fréquente de la capacité résiduelle.

Le procédé selon **l'invention**

L'invention concerne un procédé de détermination de la capacité résiduelle $C_{res}$ d'au moins une cellule électrochimique de stockage de l'énergie électrique, dans lequel on réalise au moins une série de mesures comprenant des mesures d'une tension $V_0$ et d'une température $T_0$ en début d'une sollicitation de ladite cellule électrochimique initialement relaxée, d'une tension $V_1$ et d'une température $T_1$ en fin de ladite sollicitation de ladite cellule électrochimique et après sa relaxation, et d'un courant I pendant ladite sollicitation de ladite cellule électrochimique. Pour le procédé, on réalise les étapes suivantes :

a) on détermine au moins un paramètre $\eta$ représentant un effet du vieillissement de ladite cellule électrochimique au moyen ladite série de mesures et d'un modèle de tension à vide de ladite cellule électrochimique, ledit modèle reliant la tension V de ladite cellule électrochimique à la charge C de ladite cellule électrochimique, à la température T, au moyen dudit un paramètre $\eta$ ;
b) on calcule ladite capacité résiduelle $C_{res}$ au moyen dudit modèle et dudit paramètre $\eta$.

Selon l'invention, le nombre de séries de mesures est supérieur ou égal au nombre de paramètres $\eta$ dudit modèle.

Selon un mode de réalisation de l'invention, on détermine ledit paramètre $\eta$ au moyen de ladite série de mesures en réalisant les étapes suivantes :

i) on initialise ledit paramètre $\eta$ à une valeur initiale $\eta_0$ ;
ii) on détermine une valeur d'une capacité $C_0$ de début de sollicitation au moyen dudit modèle, desdites mesures de température $T_0$ et de tension $V_0$ en début de sollicitation et dudit paramètre $\eta$ ;
iii) on détermine une valeur de capacité $C_1$ de fin de sollicitation par somme de ladite capacité $C_0$ de début de sollicitation et d'une intégrale $\Sigma$ de la mesure de courant I pendant ladite sollicitation ;
iv) on estime une valeur de tension $V_1^{est}$ de fin de sollicitation au moyen dudit modèle, de ladite valeur de capacité $C_1$ de fin de sollicitation, de la température $T_1$ en fin de sollicitation et dudit paramètre $\eta$ ; et
v) on réitère les étapes ii) à iv) en modifiant ledit paramètre $\eta$ de manière à minimiser l'écart entre la valeur de la mesure de tension $V_1$ et la valeur de tension estimée $V_1^{est}$.

Avantageusement, on modifie ledit paramètre $\eta$ au moyen d'une méthode de descente.

Selon un deuxième mode de réalisation de l'invention, on détermine un unique paramètre $\eta$ au moyen d'une unique série de mesures en cherchant par un algorithme de Newton le zéro d'une fonction $\phi(\eta)$ du type :

$$\Phi(\eta) = V_1^m - U_0\left(C_0 + \Sigma^m, T_1, \eta\right)$$ avec $V_1^m, V_0^m$ les mesures des tensions de fin et de début de sollicitation de ladite cellule électrochimique, $\Sigma^m$ l'intégrale du courant mesuré pendant ladite sollicitation de ladite cellule électrochimique, $C_0$ la capacité du début de sollicitation déterminée au moyen dudit modèle et de ladite série de mesures et $U_0$ désigne ledit modèle.

Selon un troisième mode de réalisation de l'invention, on détermine un unique paramètre $\eta$ au moyen de la détermination du minimum d'une fonction du type :

$$\min_{C_0,\Sigma,\eta} \quad \alpha\left(V_0^m - U_0\left(C_0, T_0, \eta\right)\right)^2 + \beta\left(V_1^m - U_0\left(C_0 + \Sigma, T_1, \eta\right)\right)^2 + \gamma\left(\Sigma^m - \Sigma\right)^2 \quad \text{avec} \quad V_1^m, V_0^m \quad \text{les}$$

mesures des tensions de fin et de début de sollicitation de ladite cellule électrochimique, $\Sigma^m$ l'intégrale du courant mesuré pendant ladite sollicitation de ladite cellule électrochimique, $\alpha, \beta, \gamma$ des pondérations des différentes contributions, $C_0$ la capacité du début de sollicitation déterminée au moyen dudit modèle et de ladite série de mesures et $U_0$ désigne ledit modèle.

Selon un quatrième mode de réalisation de l'invention, on détermine n paramètres $\eta$ au moyen de p séries de mesures au moyen de la détermination d'un minimum d'une fonction de la forme :

$$\min_{\{C_0^i\},\{\Sigma^i\},\eta} \quad \sum_{i=1}^{p} \alpha_i\left(V_0^{m,i} - U_0\left(C_0^i, T_0^i, \eta\right)\right)^2 + \sum_{i=1}^{p} \beta_i\left(V_1^{m,i} - U_0\left(C_0^i + \Sigma^i, T_1^i, \eta\right)\right)^2 + \sum_{i=1}^{p} \gamma_i\left(\Sigma^{m,i} - \Sigma^i\right)^2$$

avec $V_1^{m,i}, V_0^{m,i}$ les mesures des tensions de fin et de début de sollicitation de ladite cellule électrochimique pour la série de mesure i, $\Sigma^{m,i}$ l'intégrale du courant mesuré pendant ladite sollicitation de ladite cellule électrochimique pour la série de mesure i, $\alpha_i, \beta_i, \gamma_i$ des pondérations des différentes contributions pour la série de mesure i, $C_0^i$ la capacité du début de sollicitation déterminée au moyen dudit modèle et de ladite série de mesures i et $U_0$ désigne ledit modèle.

Avantageusement, on détermine le minimum de ladite fonction au moyen d'un algorithme des moindres carrés non linéaires de type Levenberg-Marquardt.

Selon l'invention, on détermine ladite capacité résiduelle $C_{res}$ au moyen desdites étapes suivantes :

i) on détermine une capacité initiale $C_i$ de ladite cellule électrochimique pour une température de référence $T_{ref}$, au moyen dudit modèle, d'une tension maximale de ladite cellule électrochimique et dudit paramètre $\eta$ ;
ii) on détermine une capacité finale $C_f$ de ladite cellule électrochimique pour ladite température de référence $T_{ref}$, au moyen dudit modèle, d'une tension minimale de ladite cellule électrochimique et dudit paramètre $\eta$ ;
iii) on calcule ladite capacité résiduelle $C_{res}$ par différence entre ladite capacité finale $C_f$ et ladite capacité initiale $C_i$.

En outre, on peut calculer ladite capacité résiduelle $C_{res}$ au moyen d'une valeur filtrée dudit paramètre $\eta$.

De préférence, on détermine l'état de santé SOH de ladite cellule électrochimique au moyen de ladite capacité résiduelle $C_{res}$.

De manière avantageuse, on contrôle ladite cellule électrochimique en fonction dudit état de santé SOH de ladite cellule électrochimique.

Avantageusement, ladite au moins une cellule électrochimique est utilisée dans un véhicule hybride ou électrique, notamment un véhicule automobile.

**Présentation succincte des figures**

D'autres caractéristiques et avantages du procédé selon l'invention, apparaîtront à la lecture de la description ci-après d'exemples non limitatifs de réalisations, en se référant aux figures annexées et décrites ci-après.

La figure 1 illustre une courbe de tension à vide pour une batterie dans un état initial non vieilli et pour une batterie dans un état vieilli.
La figure 2 illustre une courbe de tension à vide à iso-température pour un exemple.

**Description détaillée de l'invention**

L'invention concerne un procédé de détermination d'une capacité résiduelle $C_{res}$ d'une batterie. On rappelle que l'appellation générique batterie désigne ici tous les moyens de stockage d'énergie électrique et plus particulièrement des batteries, packs, modules et cellules électrochimiques.

On appelle tension à vide de la batterie un ensemble de courbes, dépendant de la température, qui relient la charge prélevée depuis la pleine charge, à la tension aux bornes de la cellule lorsque celle-ci est totalement relaxée, c'est à dire lorsqu'elle n'a pas été sollicitée (courant nul) depuis suffisamment longtemps pour que les surpotentiels aient retrouvé leur valeur d'équilibre nulle. Selon cette définition, la pleine charge correspond à une tension à vide maximale $V^{max}$ définie par le concepteur de la cellule. La batterie est considérée comme relaxée lorsque le temps écoulé depuis la fin de la sollicitation est supérieur ou égal à une durée prédéterminée, ou bien lorsque, après la fin de la sollicitation, la variation de la tension sur une période donnée devient inférieure à un seuil prédéterminé.

On entend par capacité résiduelle de la cellule, notée $C_{res}$, la valeur de la charge, prélevée depuis la pleine charge, pour laquelle la tension à vide est égale à une tension minimale $V^{min}$ définie par le concepteur de la cellule. Par définition, on considère que la cellule est "vide" lorsque cette tension minimale est atteinte.

Le procédé selon l'invention comporte les étapes suivantes :

    1) Détermination du paramètre $\eta$ du modèle
    2) Détermination de la capacité résiduelle $C_{res}$

Afin de déterminer le paramètre du modèle $\eta$ et la capacité résiduelle $C_{res}$, des mesures de propriétés de la batterie sont utilisées. Selon l'invention, on réalise au moins une série de mesures, chaque série de mesures comporte au moins les mesures suivantes :

- la température $T_0$ en début de sollicitation de la batterie,

- la tension $V_0$ en début de sollicitation de la batterie, c'est la tension mesurée lorsque la batterie est relaxée en début de sollicitation, à la température $T_0$,

- la température $T_1$ en fin de sollicitation de la batterie,

- la tension $V_1$ en fin de sollicitation de la batterie, c'est la tension mesurée à l'issue de la relaxation suivant la fin de la sollicitation, à la température $T_1$,

- le courant $I$ pendant la sollicitation de la batterie, ce courant peut permettre de calculer l'intégrale $\Sigma$ du courant correspondant à la variation de la charge pendant la sollicitation de la batterie, cette intégrale est homogène à une charge (Ah).

<u>1) Détermination du paramètre $\eta$ du modèle</u>

Au fur et à mesure de son utilisation, plusieurs caractéristiques physiques des constituants (électrodes et électrolytes) de la cellule ou des cellules constituant la batterie varient. On parle de vieillissement de la cellule. Celui-ci a diverses origines, mais entraîne notamment une modification de la tension à vide de la cellule. Lorsque le vieillissement est pris en compte, la tension à vide de la cellule est considérée alors comme dépendant, outre de la température, de $n$ paramètres, notés $\eta_i$ (formant un $n$-uplet $\eta=(\eta_1,...,\eta_n)$) représentant l'effet du vieillissement. Le choix de n dépend des connaissances disponibles pour modéliser le vieillissement. Une telle modélisation n'est pas l'objet de la présente demande. Pour des exemples de modèle, on pourra se référer notamment au document E. Prada, D. Di Domenico, Y. Creff, J. Bernard, V. Sauvant-Moynot, F. Huet. A simplified electrochemical and thermal aging model of LiFePO4-graphite Li-ion batteries: Power and Capacity Fade Simulations. Journal of The Electrochemical Society 160 (4) A616-A628, 2013. A titre d'exemple, il est possible de représenter avec un unique paramètre le phénomène de vieillissement de l'électrode négative graphite d'une cellule Li-ion par accroissement de la couche de surface (SEI), constituée par la précipitation sur cette électrode du produit de la réaction de réduction entre un solvant contenu dans l'électrolyte et le lithium cyclable.

Préalablement à la détermination du paramètre $\eta$, on construit un modèle de tension à vide de la batterie à étudier, ce modèle représente l'évolution de la tension de la batterie en prenant en compte le vieillissement de celle-ci. Pour cela, le modèle relie la tension V de la batterie (ou cellule) à la température T, à la capacité (charge) C (liée à l'intégrale du courant $\Sigma$) de la batterie (ou cellule), au moyen d'au moins un paramètre $\eta$ représentant un effet du vieillissement de la batterie (ou cellule).

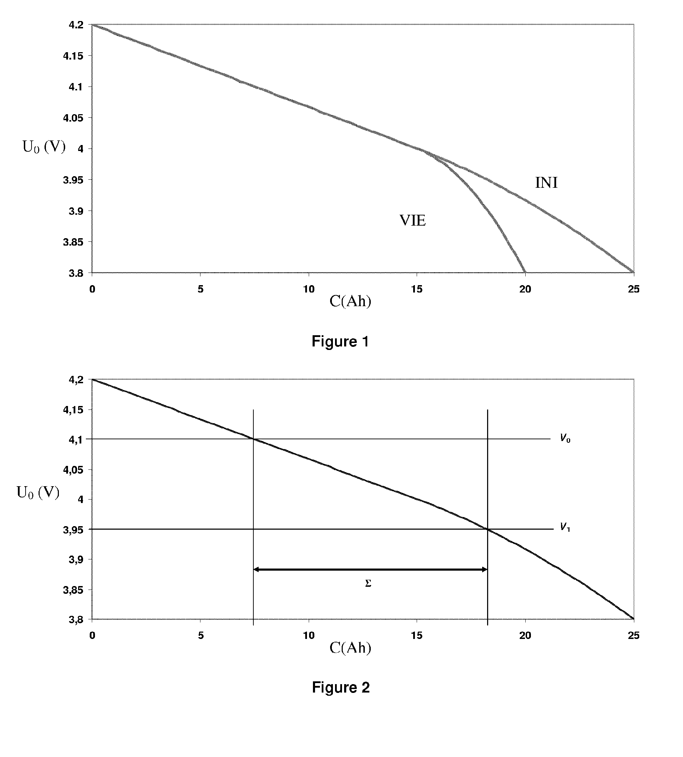

Selon l'invention, le modèle de tension à vide est formé d'un ensemble de courbes de tension à vide connues. La figure 1 représente un exemple d'une courbe de tension à vide $U_0$ (V) en fonction de la charge C (Ah) pour une batterie dans un état initial, non vieilli (INI) et pour une batterie dans un état vieilli (VIE). On remarque que les caractéristiques de la batterie dans un état vieilli sont dégradées à partir d'une certaine charge. C'est cette "dégradation" qui peut être modélisé par le paramètre $\eta$ (ou par le n-uplet $\eta$).

La capacité résiduelle $C_{res}$ de la cellule dépend de la valeur du paramètre $\eta$. Sans perte de généralité, on peut admettre que la capacité de la cellule est donnée à une température de référence, notée $T^{ref}$. Néanmoins, tout ce qui est présenté par la suite est valable dans les cas où la capacité est une fonction de la température.

A un moment donné de sa période d'utilisation (de "sa vie"), la tension à vide de la cellule est donc caractérisée par une valeur du paramètre $\eta$ (ou du $n$-uplet $\eta$).

Dans la suite de la description, le terme paramètre $\eta$ désigne les deux solutions : un unique paramètre et un n-uplet.

Pour une valeur de $\eta$ donnée, en supposant que la cellule soit à la même température aux moments de la mesure de $V_0$ et de $V_1$, ces trois grandeurs sont telles que la représentation de la figure 2 est valide. Dans la suite, une telle courbe reliant la charge prélevée $C$ à la tension à vide $U_0$ est notée $U_0(C,T,\eta)$, où $T$ est la température. La figure 2 représente donc un exemple d'une courbe de tension à vide $U_0$ (V) à iso-température en fonction de la charge C (Ah). Pour l'exemple illustré, la tension maximale $V^{\max}$ vaut 4,2 V, la tension minimale $V^{\min}$ 3,8 V, la tension en début de sollicitation $V_0$ vaut 4,1 V, la tension en fin de sollicitation $V_1$ vaut 3,95 V et la capacité résiduelle $C_{res}$ de la cellule vaut 25 Ah. L'intégrale $\Sigma$ du courant est également illustrée sur cette courbe.

Au moyen d'un tel modèle, il est possible de déterminer le paramètre $\eta$. Pour cela, on estime la valeur du paramètre $\eta$ à partir de la série de mesures réalisées préalablement. De préférence, pour estimer le paramètre $\eta$ de dimension n, on utilise p séries de mesures, avec p supérieur ou égal à n.

Selon un mode de réalisation de l'invention, on peut déterminer un unique paramètre $\eta$ (un seul paramètre est utilisé pour la représentation du vieillissement) au moyen d'une unique série de mesures, notée

$$\Theta = \left( V_0^{\,m}, V_1^{\,m}, \Sigma^{\,m} \right)$$ pour lequel l'exposant m signifie mesure. Selon ce mode de réalisation, on peut mettre en oeuvre les étapes suivantes :

- on initialise en supposant que $\eta$ vaut $\eta_0$.

- on calcule, par inversion du modèle $V_0^{\,m} = U_0\left( C_0, T_0, \eta \right)$, , une valeur de $C_0$, la capacité (charge) de la batterie en début de sollicitation. Si plusieurs valeurs de $C_0$ satisfont l'équation, la plus petite valeur est retenue si l'intégrale du courant $\Sigma^m$ est positive, la plus grande si l'intégrale $\Sigma^m$ est négative.

- on détermine la grandeur de la capacité (charge) $C_1$ en fin de sollicitation au moyen d'une formule du type $C_1 = C_0 + \Sigma^m$.

- on estime une valeur de la tension en fin de sollicitation $V_1^{\,est}$ au moyen du modèle et de la capacité de fin de sollicitation : $V_1^{\,est} = U_0\left( C_1, T_1, \eta \right)$.

- on modifie $\eta$, et on répète les étapes précédentes, jusqu'à ce qu'une mesure de l'écart entre $V_1^{\,est}$ et $V_1^{\,m}$ soit inférieure à un seuil prédéterminé. On peut choisir par exemple comme mesure de l'écart la valeur absolue de la différence, ou bien le carré de la différence.

La manière de modifier $\eta$ peut exploiter diverses approches existantes, des méthodes de descente, par exemple.

Selon une variante de réalisation, on peut limiter le nombre d'itérations à un maximum prédéterminé. Si ce maximum est atteint, on peut soit considérer que la série de mesures n'est pas exploitable et ne pas modifier l'état de vieillissement, soit choisir, parmi les valeurs de $\eta$ utilisées lors des répétitions, celle qui fournit la plus petite mesure de l'écart entre $V_1^{\,est}$ et $V_1^{\,m}$.

2) Détermination de la capacité résiduelle $C_{res}$

A partir du paramètre $\eta$ et du modèle, on détermine, lors de cette étape, la capacité résiduelle $C_{res}$ de la batterie.

Selon un mode de réalisation de l'invention, on peut réaliser les étapes suivantes :

i) on détermine une capacité (charge) initiale $C_i$ de la batterie pour une température de référence $T_{ref}$, au moyen du modèle, d'une tension maximale $V^{\max}$ de la batterie et du paramètre $\eta$ : $V^{\max} = U_0(C_i, T_{ref}, \eta)$ ;

ii) on détermine une capacité (charge) finale $C_f$ de la batterie pour une température de référence $T_{ref}$, au moyen du modèle, d'une tension minimale $V^{\min}$ de la batterie et du paramètre $\eta$ : $V^{\min} = U_0(C_f, T_{ref}, \eta)$ ;

iii) on calcule la capacité résiduelle $C_{res}$ par différence entre ladite capacité finale $C_f$ et ladite capacité initiale $C_i$ : $C_{res} = C_f - C_i$. Les tensions maximale et minimale sont fournies par le constructeur de la batterie. Ces tensions limites Vmax et Vmin dépendent de la technologie (chimie) de batterie mais aussi des conditions opératoires (température et type de sollicitation en pulse en en continu).

Les étapes i) et ii) peuvent être réalisées dans l'ordre exposé ci-dessus, dans l'ordre inverse ou simultanément.

Remarque : ces calculs supposent implicitement, aux étapes i) et ii), que le modèle est localement inversible en $C$. Si, à l'étape i), le calcul a plusieurs solutions pour $C_i$, la plus faible valeur est retenue. Si, à l'étape ii), le calcul a plusieurs solutions pour $C_f$, la plus grande valeur est retenue.

La capacité résiduelle $C_{res}$ peut être ensuite utilisée pour déterminer l'état de santé SOH de la batterie. La connaissance de la capacité résiduelle $C_{res}$ permet également de déterminer la valeur de la charge réelle de la batterie, c'est-à-dire calculée en fonction de la capacité réelle de la batterie et non pas en fonction de la capacité nominale. En fonction de l'état de santé de la batterie, on peut adapter et ajuster le contrôle de celle-ci de manière à prendre en compte ses caractéristiques vieillies, on peut également prévoir le remplacement de la batterie si on considère que celle-ci est en fin de vie (par exemple après une perte de charge de plus de 30%).

L'invention trouve son application dans le domaine des batteries aussi bien pour des applications embarquées : véhicules (automobiles, ferroviaires, aéronautiques, nautiques, aéroglisseurs...) téléphones, ordinateurs, outils portatifs, aspirateurs autonomes... que pour des applications dites stationnaires associées à la production intermittente de l'énergie électrique qui utilisent également des systèmes de stockage d'énergie de type batterie.

Variantes de réalisation

La détermination du paramètre $\eta$ peut être mise en oeuvre par plusieurs variantes de réalisation.

Selon une première variante de réalisation, on détermine un unique paramètre $\eta$ au moyen d'une unique série de mesures en cherchant par un algorithme de Newton le zéro d'une fonction $\phi(\eta)$ du type :

$$\Phi(\eta) = V_1^m - U_0\left(C_0 + \Sigma^m, T_1, \eta\right)$$ avec $V_1^m, V_0^m$ les mesures des tensions de fin et de début de sollicitation de

la batterie, $\Sigma^m$ l'intégrale du courant mesuré pendant la sollicitation de la batterie et $C_0$ la capacité du début de sollicitation déterminée au moyen du modèle et de la série de mesures. La capacité $C_0$ est la plus grande solution de

$$V_0^m = U_0\left(C_0, T_0, \eta\right)$$ si l'intégrale $\Sigma^m$ est positive, la plus petite sinon. $U_0$ désigne le modèle tel que construit précédemment.

Selon une deuxième variante de réalisation, on détermine un unique paramètre $\eta$ au moyen de la détermination du minimum d'une fonction du type :

$$\min_{C_0, \Sigma, \eta} \quad \alpha\left(V_0^m - U_0\left(C_0, T_0, \eta\right)\right)^2 + \beta\left(V_1^m - U_0\left(C_0 + \Sigma, T_1, \eta\right)\right)^2 + \gamma\left(\Sigma^m - \Sigma\right)^2$$ avec $V_1^m, V_0^m$ les mesures des tensions de fin et de début de sollicitation de la batterie, $\Sigma^m$ l'intégrale du courant mesuré pendant la sollicitation de la batterie, $\alpha, \beta, \gamma$, des pondérations des différentes contributions et $C_0$ la capacité du début de sollicitation déterminée au moyen du modèle et de la série de mesures. La capacité $C_0$ est la plus grande solution de $V_0^m = U_0\left(C_0, T_0, \eta\right)$

si l'intégrale $\Sigma^m$ est positive, la plus petite sinon. $U_0$ désigne le modèle tel que construit précédemment.

Par exemple, si on a une confiance importante dans la valeur $\Sigma^m$ de l'intégrale du courant, on prendra $\gamma$ très grand devant $\beta$, qui sera de l'ordre de $\alpha$ si on a une confiance similaire (mais moindre que dans $\Sigma^m$) dans les valeurs de $V_0^m$ et $V_1^m$. La mesure des écarts par des différences au carré dans l'expression ci-dessus est donnée à titre d'exemple.

Ce problème de minimisation peut être complété par des bornes simples sur les variables d'optimisation. Typiquement :

- $C_0$ doit être positive et inférieure à une valeur maximale (par exemple la valeur initiale de la capacité de la cellule, c'est à dire lorsque celle-ci est neuve. On prend de préférence une valeur maximale supérieure à cette valeur initiale).
- $\Sigma$ est de signe connu égal au signe de $\Sigma^m$ : sa valeur absolue est donc comprise entre 0 et la valeur prise comme valeur maximale pour $C_0$.
- $\eta$ est borné selon la manière dont est effectué a priori le paramétrage de la courbe de tension à vide.

De tels problèmes de minimisation peuvent être résolus, par exemple, par un algorithme de moindres carrés non-linéaires de type Levenberg-Marquardt.

Selon une troisième variante de réalisation, on détermine n paramètres $\eta$ au moyen de p séries de mesures. Pour cela, On suppose par ailleurs que ces p séries de mesures correspondent à des mesures suffisamment rapprochées pour qu'il soit légitime de les considérer comme procédant d'une valeur unique pour $\eta$. Autrement dit, la vitesse de vieillissement est supposée lente pour que $\eta$ puisse être considérée comme constant pendant la période de temps nécessaire à la collecte des p séries de mesures. Avec ces hypothèses, on détermine le paramètre $\eta$ au moyen de la détermination d'un minimum d'une fonction de la forme :

$$\min_{\{C_0^i\},\{\Sigma^i\},\eta} \sum_{i=1}^{p} \alpha_i \left(V_0^{m,i} - U_0\left(C_0^i, T_0^i, \eta\right)\right)^2 + \sum_{i=1}^{p} \beta_i \left(V_1^{m,i} - U_0\left(C_0^i + \Sigma^i, T_1^i, \eta\right)\right)^2 + \sum_{i=1}^{p} \gamma_i \left(\Sigma^{m,i} - \Sigma^i\right)^2$$

avec $V_1^{m,i}, V_0^{m,i}$ les mesures des tensions de fin et de début de sollicitation de la batterie pour la série de mesure i, $\Sigma^{m,i}$ l'intégrale du courant mesuré pendant la sollicitation de la batterie pour la série de mesure i, $\alpha_i, \beta_i, \gamma_i$ des pondérations

(réels positifs) des différentes contributions pour la série de mesure i et $C_0^i$ la capacité du début de sollicitation déterminée au moyen du modèle et de la série de mesures i.

Ce problème de minimisation peut être complété par des bornes simples sur les variables d'optimisation. Typiquement :

- $C_0$ doit être positive et inférieure à une valeur maximale (par exemple la valeur initiale de la capacité de la cellule, c'est à dire lorsque celle-ci est neuve. On prend de préférence une valeur maximale supérieure à cette valeur initiale).
- $\Sigma$ est de signe connu égal au signe de $\Sigma^m$ : sa valeur absolue est donc comprise entre 0 et la valeur prise comme valeur maximale pour $C_0$.
- $\eta$ est borné selon la manière dont est effectué a priori le paramétrage de la courbe de tension à vide.

De tels problèmes de minimisation peuvent être résolus, par exemple, par un algorithme de moindres carrés non-linéaires de type Levenberg-Marquardt.

Les autres variantes de réalisation concernent le déroulement du procédé et peuvent être combinées entre elles et avec les variantes décrites ci-dessus.

Selon une variante de réalisation, à l'issue de l'étape de détermination du paramètre $\eta$, on dispose d'une nouvelle valeur calculée $\eta$. On peut choisir d'utiliser directement cette valeur à l'étape de détermination de la capacité résiduelle. Alternativement, on peut choisir d'utiliser pour cette étape de détermination de la capacité résiduelle $C_{res}$ une valeur $\eta_b$ provenant d'un filtrage quelconque de la nouvelle valeur calculée $\eta$.

Rien ne garantit a priori que le problème posé soit globalement convexe. L'initialisation à la dernière valeur calculée (ou à la sortie d'un filtrage quelconque de la dernière valeur calculée) peut permettre d'éviter le basculement vers le bassin d'attraction d'un autre minimum local. Par ailleurs, il est possible, soit d'ajouter au critère d'optimisation proposé une pénalisation de la variation de $\eta$ entre deux calculs, soit d'utiliser tout algorithme d'optimisation globale (tirs multiples avec diverses valeurs pour l'initialisation de $\eta$, dans le but de déterminer un ensemble de minima locaux). Dans ce dernier cas d'utilisation d'un algorithme d'optimisation globale, le résultat retenu peut correspondre au minimum de ces minima, mais des considérations physiques peuvent aussi guider le choix d'un autre résultat. On peut par exemple préférer au minimum des minima un minimum local pour lequel un vieillissement monotone est obtenu (pour un ou plusieurs mécanismes de vieillissement).

Les effets d'hystérèse qui peuvent apparaître (courbes de tension à vide différentes en charge et en décharge) peuvent être :

- soit ignorés, lorsqu'ils sont suffisamment faibles. Ils ne nuisent alors pas au résultat du calcul.
- soit pris en compte dans le paramétrage des courbes de tension à vide. Alors, à chaque $\Sigma^{m,i}$ (de la troisième variante de réalisation) est associé un bit d'information précisant le signe du courant à la toute fin de la sollicitation.

Préliminairement aux étapes de détermination du paramètre $\eta$ et de détermination de la capacité résiduelle $C_{res}$, selon le nombre n de paramètres utilisés pour représenter le vieillissement, on sélectionne le nombre minimal p de séries de mesures à considérer pour une mise à jour. Cette sélection s'effectue selon la technologie de la batterie (ou cellule) et de la variante de réalisation. Cette sélection peut procéder itérativement. Elle s'appuie sur un ensemble de données correspondant à une succession d'états de santé de la cellule considérée. Elle peut aussi s'appuyer sur une estimation du conditionnement du problème d'optimisation à résoudre.

Le nombre $p$ de séries de mesures effectivement utilisées lors d'une mise à jour peut évoluer au fur et à mesure des mises à jour, sans jamais devenir inférieur à la valeur minimale définie pour $p$.

Des tests préliminaires permettent d'éliminer certaines séries de mesures avant les étapes de détermination du paramètre $\eta$ et de détermination de la capacité résiduelle $C_{res}$. Par exemple, il est possible de requérir que :

- la valeur absolue de l'intégrale $\Sigma$ soit strictement supérieure à un seuil prédéterminé (il est de toutes façons requis qu'elle soit strictement positive);

- la valeur absolue de l'écart entre les tensions $V_0$ et $V_1$ soit supérieure à un seuil prédéterminé;
- le signe de l'intégrale du courant $\Sigma$ soit cohérent avec le signe de l'écart $V_0$ - $V_1$, $\Sigma$ positif pour un écart positif, $\Sigma$ négatif sinon;
- le temps écoulé entre la mesure de $V_0$ et celle de $V_1$ soit inférieur à un seuil prédéterminé.
- la température lors de la mesure de $V_0$ et $V_1$ soit comprise entre des seuils minimum et maximum prédéterminés.

Par ailleurs, il est possible de requérir que les $p$ séries de mesures requises doivent être recueillies sur une durée inférieure à un seuil maximal prédéterminé.

Les critères utilisés pour l'élimination de séries de mesures peuvent varier d'une mise à jour de la capacité $C_{res}$ à une autre.

Lorsque $p$ séries de mesures valides sont disponibles, un calcul est effectué. Suite à ce calcul, il est possible, pour la constitution du prochain ensemble de $p$ séries de mesures utilisables :

- d'éliminer les q séries de mesures les plus anciens ($q$ pouvant varier de 1 à $p$) et de reprendre la collecte jusqu'à disposer de nouveau de $p$ séries de mesures valides.
- d'éliminer q séries de mesures ($q$ pouvant varier de 1 à $p$) pour ne conserver, avant de reprendre la collecte, que les $p$-$q$ séries de mesures jugées les plus représentatives. La représentativité d'une série de mesures peut, par exemple, être jugée par la valeur absolue de l'intégrale $\Sigma$ ou par la valeur absolue de l'écart entre les tensions $V_0$ et $V_1$.

Les critères utilisés pour la constitution du prochain ensemble de $p$ séries de mesures utilisables peuvent varier d'une mise à jour de la capacité $C_{res}$ à une autre.

## Revendications

1. Procédé de détermination de la capacité résiduelle $C_{res}$ d'au moins une cellule électrochimique de stockage de l'énergie électrique, dans lequel on réalise au moins une série de mesures comprenant des mesures d'une tension $V_0$ et d'une température $T_0$ en début d'une sollicitation de ladite cellule électrochimique initialement relaxée, d'une tension $V_1$ et d'une température $T_1$ en fin de ladite sollicitation de ladite cellule électrochimique et après sa relaxation, et d'un courant $I$ pendant ladite sollicitation de ladite cellule électrochimique, **caractérisé en ce qu'**on réalise les étapes suivantes :

   a) on détermine au moins un paramètre $\eta$ représentant un effet du vieillissement de ladite cellule électrochimique au moyen ladite série de mesures et d'un modèle de tension à vide de ladite cellule électrochimique, ledit modèle reliant la tension V de ladite cellule électrochimique à la charge C de ladite cellule électrochimique, à la température T, au moyen dudit un paramètre $\eta$ ;
   b) on calcule ladite capacité résiduelle $C_{res}$ au moyen dudit modèle et dudit paramètre $\eta$.

2. Procédé selon la revendication 1, dans lequel le nombre de séries de mesures est supérieur ou égal au nombre de paramètres $\eta$ dudit modèle.

3. Procédé selon l'une des revendications précédentes, on détermine ledit paramètre $\eta$ au moyen de ladite série de mesures en réalisant les étapes suivantes :

   i) on initialise ledit paramètre $\eta$ à une valeur initiale $\eta_0$ ;
   ii) on détermine une valeur d'une capacité $C_0$ de début de sollicitation au moyen dudit modèle, desdites mesures de température $T_0$ et de tension $V_0$ en début de sollicitation et dudit paramètre $\eta$ ;
   iii) on détermine une valeur de capacité $C_1$ de fin de sollicitation par somme de ladite capacité $C_0$ de début de sollicitation et d'une intégrale $\Sigma$ de la mesure de courant $I$ pendant ladite sollicitation ;
   iv) on estime une valeur de tension $V_1^{est}$ de fin de sollicitation au moyen dudit modèle, de ladite valeur de capacité $C_1$ de fin de sollicitation, de la température $T_1$ en fin de sollicitation et dudit paramètre $\eta$ ; et
   v) on réitère les étapes ii) à iv) en modifiant ledit paramètre $\eta$ de manière à minimiser l'écart entre la valeur de la mesure de tension $V_1$ et la valeur de tension estimée $V_1^{est}$.

4. Procédé selon la revendication 3, dans lequel on modifie ledit paramètre $\eta$ au moyen d'une méthode de descente.

**5.** Procédé selon l'une des revendications 1 ou 2, dans lequel on détermine un unique paramètre $\eta$ au moyen d'une unique série de mesures en cherchant par un algorithme de Newton le zéro d'une fonction $\phi(\eta)$ du type :

$$\Phi(\eta) = V_1^m - U_0\left(C_0 + \Sigma^m, T_1, \eta\right) \text{ avec } V_1^m, V_0^m \text{ les mesures des tensions de fin et de début de sollicitation}$$

de ladite cellule électrochimique, $\Sigma^m$ l'intégrale du courant mesuré pendant ladite sollicitation de ladite cellule électrochimique, $C_0$ la capacité du début de sollicitation déterminée au moyen dudit modèle et de ladite série de mesures et $U_0$ désigne ledit modèle.

**6.** Procédé selon l'une des revendications 1 ou 2, dans lequel on détermine un unique paramètre $\eta$ au moyen de la détermination du minimum d'une fonction du type :

$$\min_{C_0, \Sigma, \eta} \quad \alpha\left(V_0^m - U_0\left(C_0, T_0, \eta\right)\right)^2 + \beta\left(V_1^m - U_0\left(C_0 + \Sigma, T_1, \eta\right)\right)^2 + \gamma\left(\Sigma^m - \Sigma\right)^2 \text{ avec } V_1^m, V_0^m \text{ les me-}$$

sures des tensions de fin et de début de sollicitation de ladite cellule électrochimique, $\Sigma^m$ l'intégrale du courant mesuré pendant ladite sollicitation de ladite cellule électrochimique, $\alpha, \beta, \gamma$ des pondérations des différentes contributions, $C_0$ la capacité du début de sollicitation déterminée au moyen dudit modèle et de ladite série de mesures et $U_0$ désigne ledit modèle.

**7.** Procédé selon l'une des revendications 1 ou 2, dans lequel on détermine n paramètres $\eta$ au moyen de p séries de mesures au moyen de la détermination d'un minimum d'une fonction de la forme :

$$\min_{\{C_0^i\}, \{\Sigma^i\}, \eta} \quad \sum_{i=1}^p \alpha_i \left(V_0^{m,i} - U_0\left(C_0^i, T_0^i, \eta\right)\right)^2 + \sum_{i=1}^p \beta_i \left(V_1^{m,i} - U_0\left(C_0^i + \Sigma^i, T_1^i, \eta\right)\right)^2 + \sum_{i=1}^p \gamma_i \left(\Sigma^{m,i} - \Sigma^i\right)^2$$

avec $V_1^{m,i}, V_0^{m,i}$ les mesures des tensions de fin et de début de sollicitation de ladite cellule électrochimique pour la série de mesure i, $\Sigma^{m,i}$ l'intégrale du courant mesuré pendant ladite sollicitation de ladite cellule électrochimique pour la série de mesure i, $\alpha_i, \beta_i, \gamma_i$ des pondérations des différentes contributions pour la série de mesure i, $C_0^i$ la capacité du début de sollicitation déterminée au moyen dudit modèle et de ladite série de mesures i et $U_0$ désigne ledit modèle.

**8.** Procédé selon l'une des revendications 6 ou 7, dans lequel on détermine le minimum de ladite fonction au moyen d'un algorithme des moindres carrés non linéaires de type Levenberg-Marquadt.

**9.** Procédé selon l'une des revendications précédentes, dans lequel on détermine ladite capacité résiduelle $C_{res}$ au moyen desdites étapes suivantes :

 i) on détermine une capacité initiale $C_i$ de ladite cellule électrochimique pour une température de référence $T_{ref}$, au moyen dudit modèle, d'une tension maximale de ladite cellule électrochimique et dudit paramètre $\eta$ ;
 ii) on détermine une capacité finale $C_f$ de ladite cellule électrochimique pour ladite température de référence $T_{ref}$, au moyen dudit modèle, d'une tension minimale de ladite cellule électrochimique et dudit paramètre $\eta$ ;
 iii) on calcule ladite capacité résiduelle $C_{res}$ par différence entre ladite capacité finale $C_f$ et ladite capacité initiale $C_i$.

**10.** Procédé selon l'une des revendications précédentes, dans lequel on calcule ladite capacité résiduelle $C_{res}$ au moyen d'une valeur filtrée dudit paramètre $\eta$.

**11.** Procédé selon l'une des revendications précédentes, dans lequel on détermine l'état de santé SOH de ladite cellule électrochimique au moyen de ladite capacité résiduelle $C_{res}$.

**12.** Procédé selon la revendication 11, dans lequel on contrôle ladite cellule électrochimique en fonction dudit état de santé SOH de ladite cellule électrochimique.

**13.** Procédé selon l'une des revendications précédentes, dans lequel ladite au moins une cellule électrochimique est utilisée dans un véhicule hybride ou électrique, notamment un véhicule automobile.

Figure 1

Figure 2

Europäisches
Patentamt

European
Patent Office

Office européen
des brevets

## RAPPORT DE RECHERCHE EUROPEENNE

Numéro de la demande

EP 14 30 5265

### DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | WO 2011/128756 A1 (TOYOTA MOTOR CO LTD [JP]; TAKAHASHI KENJI [JP]; NISHI YUJI [JP]; TOMUR) 20 octobre 2011 (2011-10-20) | 1,2,9-13 | INV. G01R31/36 |
| A | * abrégé * * page 7, alinéa [0022] - page 30, alinéa [0121]; figures 1-14 * | 3-8 | |
| X | JP 2002 243813 A (NISSAN MOTOR) 28 août 2002 (2002-08-28) | 1,2,9-13 | |
| A | * abrégé; figures 1-7 * | 3-8 | |
| X | DE 10 2007 037041 A1 (BOSCH GMBH ROBERT [DE]) 12 février 2009 (2009-02-12) | 1,2,9-13 | |
| A | * abrégé * * page 3, alinéa [0010] - page 6, alinéa [0049]; figures 1-5 * | 3-8 | |
| X | US 6 366 054 B1 (HOENIG STEVEN [US] ET AL) 2 avril 2002 (2002-04-02) | 1,2,9-13 | |
| A | * abrégé * * colonne 3, ligne 8 - colonne 9, ligne 35; figures 1-4 * | 3-8 | DOMAINES TECHNIQUES RECHERCHES (IPC) |
| X,D | EP 2 259 080 A1 (PEUGEOT CITROEN AUTOMOBILES SA [FR]) 8 décembre 2010 (2010-12-08) | 1,2,9-13 | G01R |
| A | * abrégé * * page 3, ligne 19 - page 5, ligne 54; figures 1-4 * | 3-8 | |
| X | EP 0 994 362 A2 (VB AUTOBATTERIE GMBH [DE] VB AUTOBATTERIE GMBH & CO KGAA [DE]; VOLKSWA) 19 avril 2000 (2000-04-19) | 1,2,9-13 | |
| A | * abrégé * * page 2, alinéa [0012] - page 5, alinéa [0043] * | 3-8 | |

-/--

Le présent rapport a été établi pour toutes les revendications

| Lieu de la recherche | Date d'achèvement de la recherche | Examinateur |
|---|---|---|
| Munich | 25 avril 2014 | Bergado Colina, J |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

.............................................................................
& : membre de la même famille, document correspondant

EPO FORM 1503 03.82 (P04C02)

Europäisches
Patentamt

European
Patent Office

Office européen
des brevets

## RAPPORT DE RECHERCHE EUROPEENNE

Numéro de la demande

EP 14 30 5265

| | DOCUMENTS CONSIDERES COMME PERTINENTS | | |
|---|---|---|---|
| Catégorie | Citation du document avec indication, en cas de besoin, des parties pertinentes | Revendication concernée | CLASSEMENT DE LA DEMANDE (IPC) |
| X | WO 03/005052 A1 (BOSCH GMBH ROBERT [DE]; SCHOCH EBERHARD [DE]) 16 janvier 2003 (2003-01-16) | 1,2,9-13 | |
| A | * abrégé * * page 4, dernier alinéa - page 13, dernier alinéa; figures 1, 2 * ----- | 3-8 | |
| A,D | DE 10 2010 019128 A1 (DAIMLER AG [DE]) 3 novembre 2011 (2011-11-03) * le document en entier * ----- | 1-13 | |
| A,D | E. PRADA ET AL: "A Simplified Electrochemical and Thermal Aging Model of LiFePO4-Graphite Li-ion Batteries: Power and Capacity Fade Simulations", JOURNAL OF THE ELECTROCHEMICAL SOCIETY, vol. 160, no. 4, 8 février 2013 (2013-02-08), pages A616-A628, XP055089671, ISSN: 0013-4651, DOI: 10.1149/2.053304jes * le document en entier * ----- | 1-13 | |
| A | WINDARKO N A ET AL: "Hysteresis modeling for estimation of State-of-Charge in NiMH battery based on improved Takacs model", TELECOMMUNICATIONS ENERGY CONFERENCE, 2009. INTELEC 2009. 31ST INTERNATIONAL, IEEE, PISCATAWAY, NJ, USA, 18 octobre 2009 (2009-10-18), pages 1-6, XP031579295, ISBN: 978-1-4244-2490-0 * le document en entier * ----- | 1-13 | DOMAINES TECHNIQUES RECHERCHES (IPC) |
| A | EP 1 975 636 A2 (SANYO ELECTRIC CO [JP]) 1 octobre 2008 (2008-10-01) * le document en entier * ----- -/-- | 1-13 | |

Le présent rapport a été établi pour toutes les revendications

| Lieu de la recherche | Date d'achèvement de la recherche | Examinateur |
|---|---|---|
| Munich | 25 avril 2014 | Bergado Colina, J |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

.......................................................................

& : membre de la même famille, document correspondant

EPO FORM 1503 03.82 (P04C02)

Europäisches
Patentamt

European
Patent Office

Office européen
des brevets

# RAPPORT DE RECHERCHE EUROPEENNE

Numéro de la demande

EP 14 30 5265

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | EP 1 111 705 A1 (MATSUSHITA ELECTRIC IND CO LTD [JP]) 27 juin 2001 (2001-06-27) * le document en entier * ----- | 1-13 | |

DOMAINES TECHNIQUES RECHERCHES (IPC)

Le présent rapport a été établi pour toutes les revendications

| Lieu de la recherche | Date d'achèvement de la recherche | Examinateur |
|---|---|---|
| Munich | 25 avril 2014 | Bergado Colina, J |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
   .................................................................
& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 14 30 5265

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

25-04-2014

| Document brevet cité au rapport de recherche | | | Date de publication | Membre(s) de la famille de brevet(s) | | | Date de publication |
|---|---|---|---|---|---|---|---|
| WO | 2011128756 | A1 | 20-10-2011 | CN | 102844931 | A | 26-12-2012 |
| | | | | EP | 2559095 | A1 | 20-02-2013 |
| | | | | JP | 2011220917 | A | 04-11-2011 |
| | | | | KR | 20120140671 | A | 31-12-2012 |
| | | | | US | 2013099794 | A1 | 25-04-2013 |
| | | | | WO | 2011128756 | A1 | 20-10-2011 |
| JP | 2002243813 | A | 28-08-2002 | AUCUN | | | |
| DE | 102007037041 | A1 | 12-02-2009 | AUCUN | | | |
| US | 6366054 | B1 | 02-04-2002 | CA | 2446240 | A1 | 14-11-2002 |
| | | | | EP | 1384086 | A1 | 28-01-2004 |
| | | | | JP | 4132036 | B2 | 13-08-2008 |
| | | | | JP | 2004530880 | A | 07-10-2004 |
| | | | | KR | 20040015242 | A | 18-02-2004 |
| | | | | US | 6366054 | B1 | 02-04-2002 |
| | | | | WO | 02091007 | A1 | 14-11-2002 |
| EP | 2259080 | A1 | 08-12-2010 | EP | 2259080 | A1 | 08-12-2010 |
| | | | | FR | 2946150 | A1 | 03-12-2010 |
| EP | 0994362 | A2 | 19-04-2000 | CZ | 9903638 | A3 | 12-07-2000 |
| | | | | DE | 19847648 | A1 | 20-04-2000 |
| | | | | EP | 0994362 | A2 | 19-04-2000 |
| | | | | ES | 2281154 | T3 | 16-09-2007 |
| | | | | US | 6163133 | A | 19-12-2000 |
| WO | 03005052 | A1 | 16-01-2003 | EP | 1417503 | A1 | 12-05-2004 |
| | | | | JP | 2004521365 | A | 15-07-2004 |
| | | | | US | 2004032264 | A1 | 19-02-2004 |
| | | | | WO | 03005052 | A1 | 16-01-2003 |
| DE | 102010019128 | A1 | 03-11-2011 | AUCUN | | | |
| EP | 1975636 | A2 | 01-10-2008 | EP | 1975636 | A2 | 01-10-2008 |
| | | | | JP | 2008241358 | A | 09-10-2008 |
| | | | | US | 2008238371 | A1 | 02-10-2008 |
| EP | 1111705 | A1 | 27-06-2001 | CN | 1314012 | A | 19-09-2001 |
| | | | | EP | 1111705 | A1 | 27-06-2001 |
| | | | | JP | 3669673 | B2 | 13-07-2005 |
| | | | | JP | 2001006756 | A | 12-01-2001 |
| | | | | KR | 100440630 | B1 | 21-07-2004 |
| | | | | US | 6480003 | B1 | 12-11-2002 |
| | | | | WO | 0079634 | A1 | 28-12-2000 |

EPO FORM P0460

Pour tout renseignement concernant cette annexe : voir Journal Officiel de l'Office européen des brevets, No.12/82

**EP 2 775 313 A1**

**ANNEXE AU RAPPORT DE RECHERCHE EUROPEENNE
RELATIF A LA DEMANDE DE BREVET EUROPEEN NO.**

EP 14 30 5265

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

25-04-2014

| Document brevet cité au rapport de recherche | Date de publication | Membre(s) de la famille de brevet(s) | Date de publication |
|---|---|---|---|
| ------------------------------------------------------------------------------------ | | | |

Pour tout renseignement concernant cette annexe : voir Journal Officiel de l'Office européen des brevets, No.12/82

16

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- DE 102010019128 A1
- FR 2946150 A1

- FR 2946150

**Littérature non-brevet citée dans la description**

- **E. PRADA ; D. DI DOMENICO ; Y. CREFF ; J. BERNARD ; V. SAUVANT-MOYNOT ; F. HUET.** A simplified electrochemical and thermal aging model of LiFePO4-graphite Li-ion batteries: Power and Capacity Fade Simulations. *Journal of The Electrochemical Society,* 2013, vol. 160 (4), A616-A628